# EUROPEAN PATENT APPLICATION

(11) **EP 2 632 005 A1**
(43) Date of publication of application: **28.08.2013**
(21) Application number: 11834419.1
(22) Date of filing: 20.10.2011
(51) Int. Cl.: H02G 3/16, H05K 1/05

(54) **METAL CORE SUBSTRATE AND ELECTRICAL CONNECTION BOX USING SAID METAL CORE SUBSTRATE**

(30) Priority: 20.10.2010 JP 2010235151
(71) Applicant: Yazaki Corporation, Minato-ku Tokyo 108-8333 (JP)
(72) Inventor: OOISHI, Manabu, Kakegawa-shi Shizuoka 437-1414 (JP); SUGIURA, Maki, Kakegawa-shi Shizuoka 437-1414 (JP); YAMAMOTO, Kazuhiro, Kakegawa-shi Shizuoka 437-1414 (JP)
(74) Representative: Grünecker, Kinkeldey, Stockmair & Schwanhäusser
(86) International application number: PCT/JP2011/074127
(87) International publication number: WO 2012/053580

(57) **Abstract**

[Problem] There is provided an electrical junction box using a metal core substrate able to prevent bending. [Solution] The electrical junction box is provided with a metal core substrate (1) including: a rectangular-shaped core metal layer (2) in which two core metal plates (2a, 2b) are arranged with a slit-shaped gap (3) therebetween; and insulating layers filling the gap (3) and integrating the two core metal plates (2a, 2b) by covering surfaces of the core metal plates (2a, 2b). Electric power from a battery is inputted into the core metal plate (2a), and electric power from an alternator is inputted into the core metal plate (2b). The gap (3) includes: a first straight portion (31) vertically extended straight from one side of the core metal layer (2); a second straight portion (32) vertically extended straight from another side of the core metal layer (2), parallel to a virtual extended line (P) of the first straight portion (31), and not arranged in the same line as the first straight portion (31); and a square-U-shaped portion (33).

## Description

### [Technical Field]

This invention relates to a metal core substrate and an electrical junction box for distributing electric power using the metal core substrate.

### [Back ground Art]

Various electronic devices are mounted on a vehicle. An electrical junction box is arranged at a proper place in the vehicle for distributing electric power to the various electronic devices. A structure of the electrical junction box is varied depending on a vehicle type. For example, there is an electrical junction box for distributing electric power using a metal core substrate as shown in PTL 1.

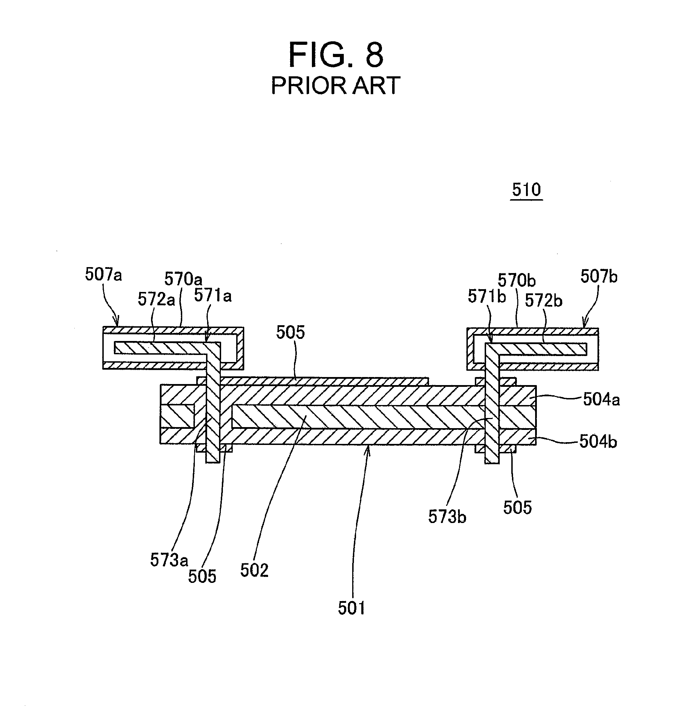

Further, as shown in Fig. 8, an electrical junction box 510 is known in which a core metal plate 502 of a metal core substrate 501 is used as not only as a radiator but also as a part of an electric power distributing circuit. This electrical junction box 510 distributes electric power from a battery and an alternator to a plurality of electronic devices, and includes: a sheet of metal core substrate 501; a plurality of electronic components mounted on a surface of the metal core substrate 501; a connector 507a connected to the battery; a connector 507b connected to the alternator; and a not-shown case for receiving these.

The metal core substrate 501 is provided with a sheet of core metal plate 502, insulating layers 504a, 504b covering a surface of the core metal plate 502, and conductive patterns 505 formed on surfaces of the insulating layers 504a, 504b. The conductive patterns 505 are made of copper foil.

The connector 507a is composed of an L-shaped terminal 571a and a connector housing 570a. The terminal 571a is provided with a first connecting portion 572a to be connected to a connector of a wiring harness connected to the battery, and a second connecting portion 573a attached to the metal core substrate 501. The first connecting portion 572a is disposed in an inside of the connector housing 570a. The second connecting portion 573a is attached to the metal core substrate 501 in a manner penetrating the metal core substrate 501, electrically connected to the conductive patterns 505, and isolated from the core metal plate 502.

The connector 507b is composed of an L-shaped terminal 571b and a connector housing 570b. The terminal 571b is provided with a first connecting portion 572b to be connected to a connector of a wiring harness connected to the alternator, and a second connecting portion 573b attached to the metal core substrate 501. The first connecting portion 572b is disposed in an inside of the connector housing 570b. The second connecting portion 573b is attached to the metal core substrate 501 in a manner penetrating the metal core substrate 501, and electrically connected to the conductive patterns 505 and the core metal plate 502.

In this way, in the electrical junction box 510, the electric power distributing circuit from the battery is only composed of the conductive patterns 505 formed on surfaces of the insulating layers 504a, 504b. The electric power distributing circuit from the alternator is only composed of the conductive patterns 505 and the core metal plate 502. However, because the conductive patterns 505 are thinner than the core metal plate 502, the electric power distributing circuit from the battery needs a large surface area. Therefore, there is a problem that the metal core substrate 501 becomes large-sized.

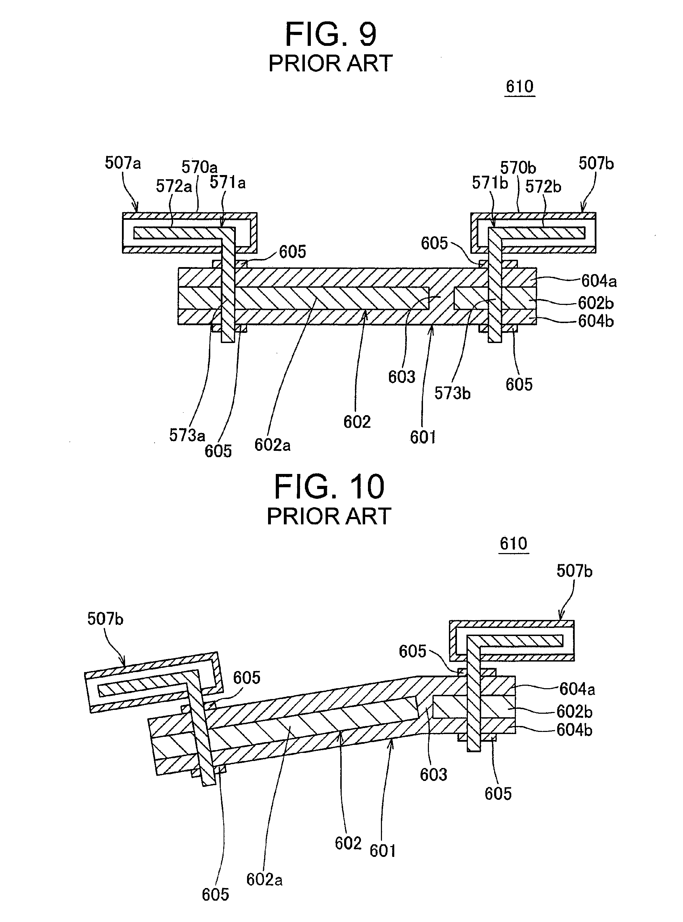

For solving this problem, as an electrical junction box 610 shown in Fig. 9, a core metal plate 602 of a metal core substrate 601 is divided into two parts by forming a straight slit 603 on the core metal plate 602. One divided part 602a is used as the electric power distributing circuit from the battery, and the other divided part 602b is used as electric power distributing circuit from the alternator. Thereby, the metal core substrate 601 is prevented from being large-sized.

Further, the reference signs 604a, 604b in Fig. 9 indicate insulating layers for filling the slit 603 and integrating the divided core metal plate 602 by covering surfaces of the core metal plate 602. Further, the reference signs 605 in Fig. 9 indicate conductive patterns formed on surfaces of the insulating layers 604a, 604b. Further, the reference sign 570a in Fig. 9 indicates a connector to be connected to the battery similar to Fig. 8, and the reference sign 570b in Fig. 9 indicates a connector to be connected to the alternator similar to Fig. 8.

### [Citation List]

### [Patent Literature]

[PTL 1]
   JP, A, 2007-325345

### [Summary of Invention]

### [Technical Problem]

However, when the straight slit 603 is formed on the core metal plate 602 to divide the core metal plate 602 into two parts as the electrical junction box 610 shown in Fig. 9, there is a problem that the metal core substrate 601 may be bent as shown in Fig. 9 by weights of the electronic components mounted on the metal core substrate 601 and the metal core substrate 601 itself acting on the slit 603 of which strength is lower than the other portions.

Accordingly, an object of the present invention is to provide a metal core substrate able to prevent bending, and to provide an electrical junction box using the metal core substrate.

### [Solution to Problem]

For attaining the object, according to a first aspect of the present invention, there is provided a metal core substrate including:
a core metal layer provided with a plurality of core metal plates arranged with a slit-shaped gap therebetween;
an insulating layer filling the gap and integrating the plurality of core metal plates by covering surfaces of the core metal plates,
wherein the gap is not straight.

According to a second aspect of the present invention, there is provided the metal core substrate as described in the first aspect,
wherein the core metal layer is in a rectangular shape, and
wherein the gap at least includes: a first straight portion extended vertically from one side of the rectangular shape; and a second straight portion extended vertically from another side of the rectangular shape, parallel to a virtual extended line of the first straight portion, and not in the same straight line as the first straight portion.

According to a third aspect of the present invention, there is provided the metal core substrate as described in the first aspect,
wherein one of the core metal plates adjacent to each other having the gap therebetween is provided with a convex portion projected toward the other core metal plate, and
wherein the other core metal plate is provided with a concave portion where the convex portion is positioned.

According to a fourth aspect of the present invention, there is provided the metal core substrate as described in the second aspect,
wherein one of the core metal plates adjacent to each other having the gap therebetween is provided with a convex portion projected toward the other core metal plate, and
wherein the other core metal plate is provided with a concave portion where the convex portion is positioned.

According to a fifth aspect of the present invention, there is provided an electrical junction box including:
the metal core substrate described in any one of the first to fourth aspects,
and distributing electric power respectively inputted into the core metal plates from a plurality of power sources.

### [Advantageous Effects of Invention]

According to the invention described in the first aspect, because the gap of which strength is lower than the other portions is not straight, the low strength portion is dispersed in comparison to a case where the gap is straight, and the metal core substrate is prevented from being bent.

According to the invention described in the second aspect, because the core metal layer is in a rectangular shape, and the gap at least includes: a first straight portion extended from one side of the rectangular shape; and a second straight portion extended from another side of the rectangular shape, parallel to a virtual extended line of the first straight portion, and not in the same straight line as the first straight portion, the metal core substrate is prevented from being bent along the first and second straight portions.

According to the invention described in the third and fourth aspects, one of the core metal plates adjacent to each other having the gap therebetween is provided with a convex portion projected toward the other core metal plate, and the other core metal plate is provided with a concave portion where the convex portion is positioned, thereby the gap is formed in a zigzag pattern. Therefore, the low strength portion is dispersed in comparison to a case where the gap is straight, and a resin amount for bonding the core metal plates to each other is increased because a length of the gap is increased. Therefore, the metal core substrate is prevented from being bent.

According to the invention described in the fifth aspect, when the plurality of core metal plates are used as electric power distributing circuits from the plurality of power sources, the metal core substrate is prevented from being large-sized.

### [Brief Description of Drawings]

[Fig. 1]

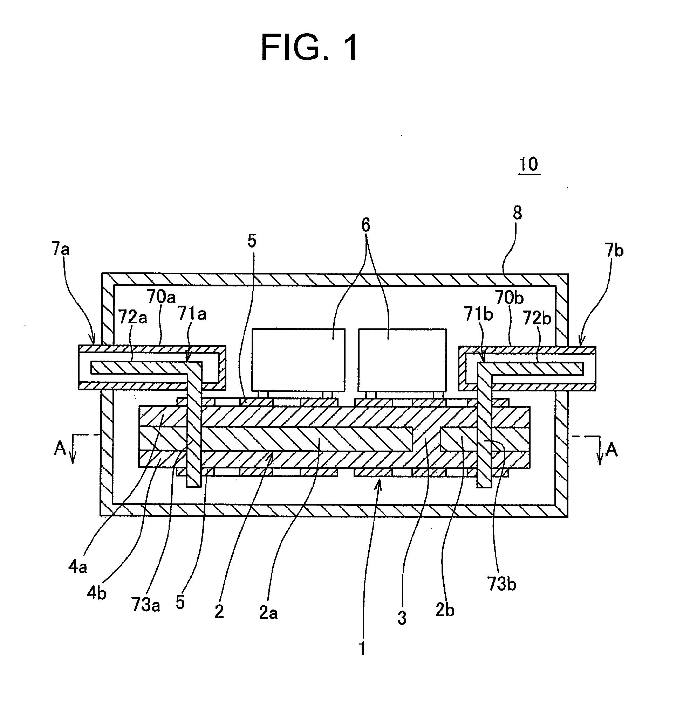

   Fig. 1 is a schematic sectional view showing a configuration of an electrical junction box according to a first embodiment of the present invention.
[Fig. 2]

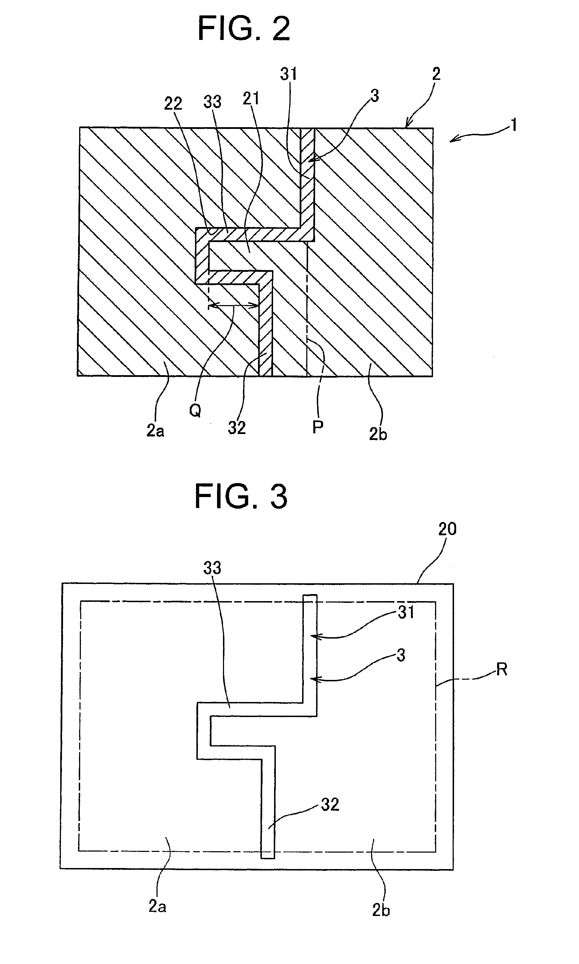

   Fig. 2 is a sectional view taken on line A -A of a metal core substrate shown in Fig. 1.
[Fig. 3]
   Fig. 3 is an explanatory view explaining a production method of the metal core substrate shown in Fig. 2.
[Fig. 4]

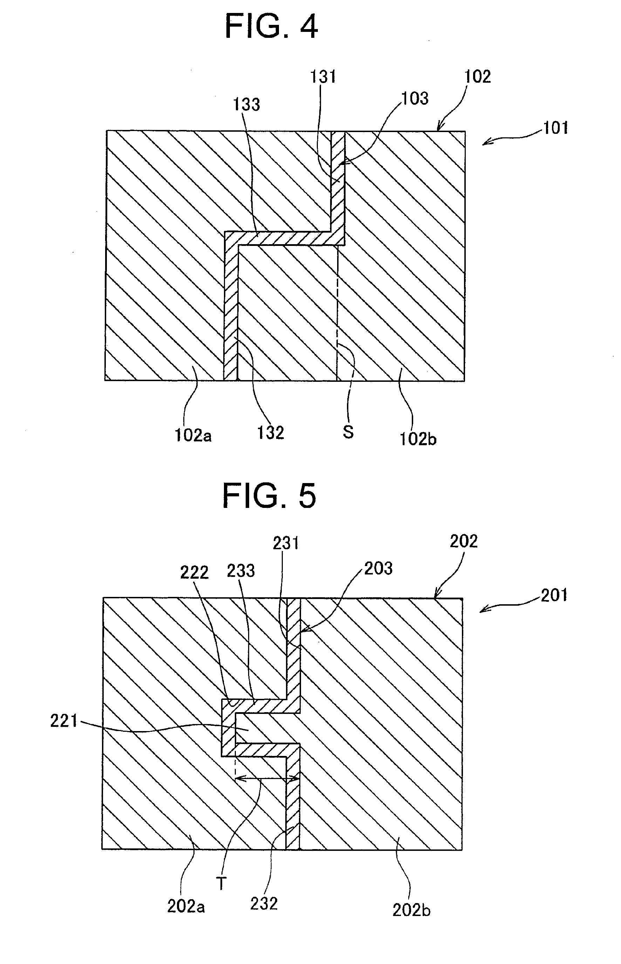

   Fig. 4 is a sectional view showing a metal core substrate as a component of an electrical junction box according to a second embodiment of the present invention.
[Fig. 5]
   Fig. 5 is a sectional view showing a metal core substrate as a component of an electrical junction box according to a third embodiment of the present invention.
[Fig. 6]

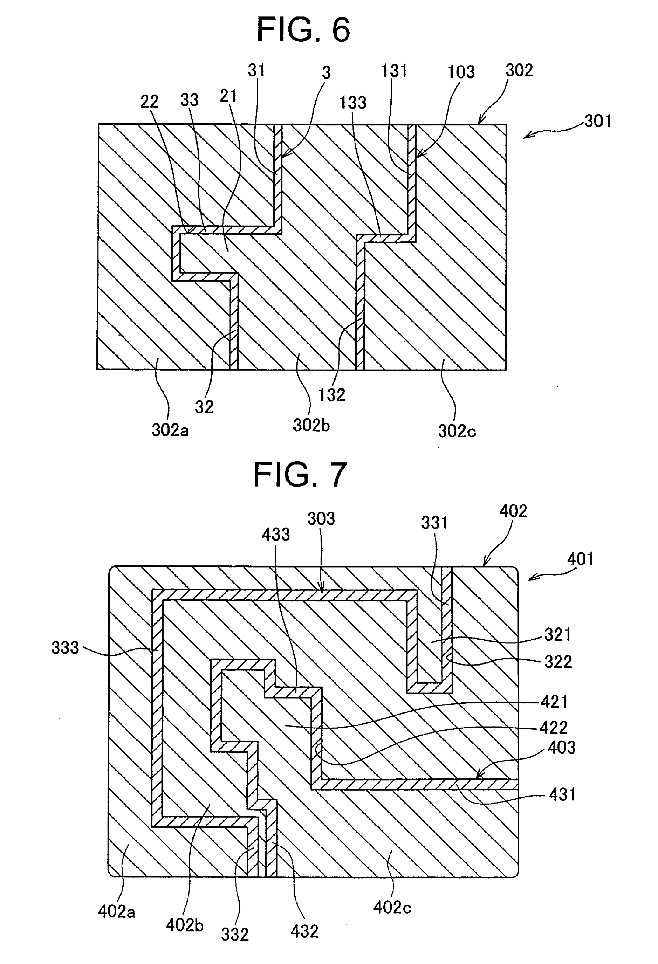

   Fig. 6 is a sectional view showing a metal core substrate as a component of an electrical junction box according to a fourth embodiment of the present invention.
[Fig. 7]
   Fig. 7 is a sectional view showing a metal core substrate as a component of an electrical junction box according to a fifth embodiment of the present invention.
[Fig. 8]
   Fig. 8 is a schematic sectional view showing a configuration of a conventional electrical junction box.
[Fig. 9]
   Fig. 9 is a schematic sectional view showing a configuration of another conventional electrical junction box.
[Fig. 10]
   Fig. 10 is a sectional view showing a condition that a metal core substrate shown in Fig. 9 is deformed.

### [Description of Embodiments]

### (First Embodiment)

Hereinafter, a metal core substrate and an electrical junction box according to a first embodiment of the present invention will be explained with reference to Figs. 1 to 3.

An electrical junction box 10 of this embodiment is mounted on a vehicle, and distributes electric power from a battery and an alternator to a plurality of electronic devices. As shown in Fig. 1, the electrical junction box 10 includes: a sheet of metal core substrate 1; a plurality of electronic components 6 mounted on a surface of the metal core substrate 1; a connector 7a to be connected to the battery; a connector 7b to be connected to the alternator; and a case for receiving them.

As shown in Figs. 1 and 2, the metal core substrate 1 is provided with a rectangular-shaped core metal layer 2 in a plan view in which two core metal plates 2a, 2b are arranged in the same plane via a slit-shaped gap 3, insulating layers 4a, 4b filling the gap 3 and integrating the two core metal plates 2a, 2b by covering surfaces of the core metal plates 2a, 2b, conductive patters 5 formed on surfaces of the insulating layers 4a, 4b, and a plurality of not-shown through-holes. The insulating layers 4a, 4b are made of prepreg which is a glass fiber fabric impregnated with epoxy resin. Namely, the gap 3 is filled with epoxy resin and hardened. The conductive patters 5 are made of copper foil.

The connector 7a is composed of an L-shaped terminal 71a and a connector housing 70a. The terminal 71a is provided with a first connecting portion 72a to be connected to a connector of a wiring harness connected to the battery, and a second connecting portion 73a attached to the metal core substrate 1. The first connecting portion 72a is disposed in an inside of the connector housing 70a. The second connecting portion 73a is attached to the metal core substrate 1 in a manner penetrating the metal core substrate 1, and electrically connected to the conductive patters 5 and one core metal plate 2a.

The connector 7b is composed of an L-shaped terminal 71b and a connector housing 70b. The terminal 71b is provided with a first connecting portion 72b to be connected to a connector of a wiring harness connected to the alternator, and a second connecting portion 73b attached to the metal core substrate 1. The first connecting portion 72b is disposed in an inside of the connector housing 70b. The second connecting portion 73b is attached to the metal core substrate 1 in a manner penetrating the metal core substrate 1, and electrically connected to the conductive patters 5 and the other core metal plate 2b.

Such an electrical junction box 10 splits the electric power inputted from the battery via the wiring harness and the connector 7a to the one core metal plate 2a into the conductive patters 5 and the electronic components 6, and distributes to the electronic devices. Further, the electrical junction box 10 splits the electric power inputted from the alternator via the wiring harness and the connector 7b to the other core metal plate 2b into the conductive patters 5 and the electronic components 6, and distributes to the electronic devices.

In this way, according to the present invention, the two core metal plates 2a, 2b are not only used as a radiator but also used as a part of the electric power distributing circuit. Thereby, the metal core substrate 1 is prevented from being large-sized.

Further, in the electrical junction box 10 of the present invention, for preventing the metal core substrate 1 from being bent by weights of the electronic components 6 and the metal core substrate 1 itself acting on the gap 3 of which strength is lower than the other portions, the gap is formed in a shape explained below to increase the strength.

As shown in Fig. 2, the gap 3 is not in a straight shape. Namely the gap 3 includes: a first straight portion 31 vertically extended straight from one side of the rectangular core metal layer 2; a second straight portion 32 vertically extended straight from another side, namely, an opposite side of the core metal layer 2, parallel to a virtual extended line P of the first straight portion 31, and not arranged in the same line as the first straight portion 31; and a square-U-shaped portion 33 connecting an end of the first straight portion 31 to an end of the second straight portion 32. A width of the gap 3 is from 0.5 mm to 1.0 mm.

Further, among the two core metal plates 2a, 2b adjacent to each other having the gap 3 therebetween, one core metal plate 2b is provided with a convex portion 21 projected toward the other core metal plate 2a, and the other core metal plate 2a is provided with a concave portion 22 in which the convex portion 21 is positioned. A projecting length Q of the convex portion 21 from the second straight portion 32 is not less than 10 mm.

In this way, according to the present invention, because the gap 3 is not straight, the low strength portion is dispersed in comparison to a case where the gap 3 is straight; thereby the metal core substrate 1 is prevented from being bent. Further, because the first straight portion 31 and the second straight portion 32 are not arranged in the same straight line, the metal core substrate 1 is prevented from being bent along the first straight portion 31 and the second straight portion 32. Further, because the gap 3 is formed in a zigzag pattern, the low strength portion is dispersed in comparison to a case where the gap 3 is straight, and a resin amount for bonding the core metal plates 2a, 2b to each other is increased because a length of the gap 3 is increased; thereby the metal core substrate 1 is prevented from being bent.

Further, according to the present invention, as described above, when the projecting length Q of the convex portion 21 from the second straight portion 32 is not less than 10 mm, an effect of preventing the metal core substrate 1 from being deformed is attained.

Further, the two core metal plates 2a, 2b are made from a sheet of metal plate 20 shown in Fig. 3. Namely, the metal core substrate 1 is formed by punching the gap 3 in the metal plate 20, and laminating front and rear surfaces of the metal plate 20 with the prepreg, and then removing an outer portion of a chain line R in the metal plate 20.

In this way, according to the present invention, there is provided the electrical junction box 10 able to prevent the metal core substrate 1 from being large-sized, and to prevent the metal core substrate 1 from being bent.

### (Second Embodiment)

A metal core substrate and an electrical junction box according to a second embodiment of the present invention will be explained with reference to Fig. 4. The electrical junction box of this embodiment has the same configuration as the electrical junction box 10 explained in the first embodiment except to include a metal core substrate 101 shown in Fig. 4 instead of the metal core substrate 1.

As shown in Fig. 4, the metal core substrate 101 is provided with a rectangular-shaped core metal layer 102 in a plan view in which two core metal plates 102a, 102b are arranged in the same plane via a slit-shaped gap 103, insulating layers (not shown) filling the gap 103 and integrating the two core metal plates 102a, 102b by covering surfaces of the core metal plates 102a, 102b, conductive patters (not shown) formed on surfaces of the insulating layers, and a plurality of not-shown through-holes. The insulating layers have the same configuration as the insulating layers 4a, 4b explained in the first embodiment.

The gap 103 is not in a straight shape. Namely the gap 103 includes: a first straight portion 131 vertically extended straight from one side of the rectangular core metal layer 102; a second straight portion 132 vertically extended straight from another side, namely, an opposite side of the core metal layer 102, parallel to a virtual extended line S of the first straight portion 131, and not arranged in the same line as the first straight portion 131; and a third straight portion 33 connecting an end of the first straight portion 131 to an end of the second straight portion 132. A width of the gap 103 is from 0.5 mm to 1.0 mm.

In this way, according to the present invention, because the gap 103 is not straight, the low strength portion is dispersed in comparison to a case where the gap 103 is straight; thereby the metal core substrate 101 is prevented from being bent. Further, because the first straight portion 131 and the second straight portion 132 are not arranged in the same straight line, the metal core substrate 101 is prevented from being bent along the first straight portion 131 and the second straight portion 132.

### (Third Embodiment)

A metal core substrate and an electrical junction box according to a third embodiment of the present invention will be explained with reference to Fig. 5. The electrical junction box of this embodiment has the same configuration as the electrical junction box 10 explained in the first embodiment except to include a metal core substrate 201 shown in Fig. 5 instead of the metal core substrate 1.

As shown in Fig. 5, the metal core substrate 201 is provided with a rectangular-shaped core metal layer 202 in a plan view in which two core metal plates 202a, 202b are arranged in the same plane via a slit-shaped gap 203, insulating layers (not shown) filling the gap 203 and integrating the two core metal plates 202a, 202b by covering surfaces of the core metal plates 202a, 202b, conductive patters (not shown) formed on surfaces of the insulating layers, and a plurality of not-shown through-holes. The insulating layers have the same configuration as the insulating layers 4a, 4b explained in the first embodiment.

The gap 203 is not in a straight shape. Namely the gap 203 includes: a first straight portion 231 vertically extended straight from one side of the rectangular core metal layer 202; a second straight portion 232 vertically extended straight from another side, namely, an opposite side of the core metal layer 202, and arranged in the same line as the first straight portion 231; and a square-U-shaped portion 233 connecting an end of the first straight portion 231 to an end of the second straight portion 232. A width of the gap 203 is from 0.5 mm to 1.0 mm.

Further, among the two core metal plates 202a, 202b adjacent to each other having the gap 203 therebetween, one core metal plate 202b is provided with a convex portion 221 projected toward the other core metal plate 202a, and the other core metal plate 202a is provided with a concave portion 222 in which the convex portion 221 is positioned. A projecting length T of the convex portion 221 from the straight portions 231, 232 is not less than 10 mm.

In this way, according to the present invention, because the gap 203 is not straight, the low strength portion is dispersed in comparison to a case where the gap 203 is straight; thereby the metal core substrate 201 is prevented from being bent. Further, because the gap 203 is formed in a zigzag pattern, the low strength portion is dispersed in comparison to a case where the gap 203 is straight, and a resin amount for bonding the core metal plates 202a, 202b to each other is increased because a length of the gap 203 is increased; thereby the metal core substrate 201 is prevented from being bent.

### (Fourth Embodiment)

A metal core substrate and an electrical junction box according to a fourth embodiment of the present invention will be explained with reference to Fig. 6.

An electrical junction box of this embodiment is mounted on a vehicle, and distributes electric power from three sources, namely, a battery, a first alternator, and a second alternator to a plurality of electronic devices. This electrical junction box includes: a sheet of metal core substrate 301 shown in Fig. 6; a plurality of electronic components mounted on a surface of the metal core substrate 301; a connector to be connected to the battery; a connector to be connected to the first alternator; a connector to be connected to the second alternator; and a case for receiving them.

As shown in Fig. 6, the metal core substrate 301 is provided with a rectangular-shaped core metal layer 302 in a plan view in which three core metal plates 302a, 302b, 302c are arranged in the same plane via slit-shaped gaps 3, 103, insulating layers (not shown) filling the gaps 3, 103 and integrating the three core metal plates 302a, 302b, 302c by covering surfaces of the core metal plates 302a, 302b, 302c, conductive patters (not shown) formed on surfaces of the insulating layers, and a plurality of not-shown through-holes. The insulating layers have the same configuration as the insulating layers 4a, 4b explained in the first embodiment.

The gap 3 includes: a first straight portion 31 vertically extended straight from one side of the rectangular core metal layer 302; a second straight portion 32 vertically extended straight from another side, namely, an opposite side of the core metal layer 302, parallel to a virtual extended line of the first straight portion 31, and not arranged in the same line as the first straight portion 31; and a square-U-shaped portion 33 connecting an end of the first straight portion 31 to an end of the second straight portion 32. A width of the gap 3 is from 0.5 mm to 1.0 mm.

Further, among the two core metal plates 302a, 302b adjacent to each other having the gap 3 therebetween, one core metal plate 302b is provided with a convex portion 21 projected toward the other core metal plate 302a, and the other core metal plate 302a is provided with a concave portion 22 in which the convex portion 21 is positioned. A projecting length of the convex portion 21 from the second straight portion 32 is not less than 10 mm.

The gap 103 includes: a first straight portion 131 vertically extended straight from one side of the rectangular core metal layer 302; a second straight portion 132 vertically extended straight from another side, namely, an opposite side of the core metal layer 302, parallel to a virtual extended line of the first straight portion 131, and not arranged in the same line as the first straight portion 131; and a third straight portion 33 connecting an end of the first straight portion 131 to an end of the second straight portion 132. A width of the gap 103 is from 0.5 mm to 1.0 mm.

The electrical junction box of this embodiment splits the electric power inputted from the three power sources via the wiring harnesses and the connectors to the core metal plates 302a, 302b, 302c into the conductive patters and the electronic components, and distributes to the electronic devices.

In this way, according to the present invention, the core metal layer 302 may be composed of a plurality of gaps 3, 103 and three or more core metal plates 302a, 302b, 302c.

A metal core substrate and an electrical junction box according to a fifth embodiment of the present invention will be explained with reference to Fig. 7. The electrical junction box of this embodiment has the same configuration as the electrical junction box explained in the fourth embodiment except to include a metal core substrate 401 shown in Fig. 7 instead of the metal core substrate 301.

As shown in Fig. 7, the metal core substrate 401 is provided with a rectangular-shaped core metal layer 402 in a plan view in which three core metal plates 402a, 402b, 402c are arranged in the same plane via slit-shaped gaps 303, 403, insulating layers (not shown) filling the gaps 303, 403 and integrating the three core metal plates 402a, 402b, 402c by covering surfaces of the core metal plates 402a, 402b, 402c, conductive patters (not shown) formed on surfaces of the insulating layers, and a plurality of not-shown through-holes. The insulating layers have the same configuration as the insulating layers 4a, 4b explained in the first embodiment.

The gap 303 includes: a first straight portion 331 vertically extended straight from one side of the rectangular core metal layer 402; a second straight portion 332 vertically extended straight from another side, namely, an opposite side of the core metal layer 402, parallel to a virtual extended line of the first straight portion 331, and not arranged in the same line as the first straight portion 331; and an intermediate portion 333 connecting an end of the first straight portion 331 to an end of the second straight portion 332. A width of the gap 303 is from 0.5 mm to 1.0 mm.

The gap 403 includes: a straight portion 431 vertically extended straight from one side of the rectangular core metal layer 402; a straight portion 432 vertically extended straight from another side, namely, a crossing side of the core metal layer 402; and an intermediate portion 433 connecting an end of the straight portion 431 to an end of the straight portion 432. A width of the gap 403 is from 0.5 mm to 1.0 mm.

Among the two core metal plates 402a, 402b adjacent to each other having the gap 303 therebetween, one core metal plate 402a is provided with a convex portion 321 projected toward the other core metal plate 402b, and the other core metal plate 402b is provided with a concave portion 322 in which the convex portion 321 is positioned. A projecting length of the convex portion 321 is not less than 10 mm.

Further, among the two core metal plates 402b, 402c adjacent to each other having the gap 403 therebetween, one core metal plate 402c is provided with a convex portion 421 projected toward the other core metal plate 402b, and the other core metal plate 402b is provided with a concave portion 422 in which the convex portion 421 is positioned. A projecting length of the convex portion 421 from the straight portion 431 is not less than 10 mm.

The electrical junction box of this embodiment splits the electric power inputted from the three power sources via the wiring harnesses and the connectors to the core metal plates 402a, 402b, 402c into the conductive patters and the electronic components, and distributes to the electronic devices.

In this way, according to the present invention, because the gaps 303, 403 are not straight, the low strength portion is dispersed in comparison to a case where the gaps 303, 403 are straight; thereby the metal core substrate 401 is prevented from being bent. Further, because the gaps 303, 403 are formed in a zigzag pattern, the low strength portion is dispersed in comparison to a case where the gaps 303, 403 are straight, and a resin amount for bonding the core metal plates 402a, 402b, 402c to each other is increased because lengths of the gaps 303, 403 are increased; thereby the metal core substrate 401 is prevented from being bent.

Incidentally, the above embodiment only shows a representative example of the present invention. The present invention is not limited to the embodiment. Namely, various modifications can be practiced within a scope of the present invention.

### [Reference Signs List]

1, 101, 201, 301, 401 metal core substrate
2, 102, 202, 302, 402 core metal layer
2a, 2b, 102a, 102b, 202a, 202b, 302a, 302b, 302c, 402a, 402b, 402c core metal plate
3, 103, 203, 303, 403 gap
4a, 4b insulating layer
10 electrical junction box
21, 221, 321, 421 convex portion
22, 222, 322, 422 concave portion
31, 131, 331 first straight portion
32, 132, 332 second straight portion
P, S virtual extended line

## Claims

1. A metal core substrate comprising:
a core metal layer provided with a plurality of core metal plates arranged with a slit-shaped gap therebetween;
an insulating layer filling the gap and integrating the plurality of core metal plates by covering surfaces of the core metal plates,
wherein the gap is not straight.

2. The metal core substrate as claimed in claim 1,
wherein the core metal layer is in a rectangular shape, and
wherein the gap at least includes: a first straight portion extended vertically from one side of the rectangular shape; and a second straight portion extended vertically from another side of the rectangular shape, parallel to a virtual extended line of the first straight portion, and not in the same straight line as the first straight portion.

3. The metal core substrate as claimed in claim 1,
wherein one of the core metal plates adjacent to each other having the gap therebetween is provided with a convex portion projected toward the other core metal plate, and
wherein the other core metal plate is provided with a concave portion where the convex portion is positioned.

4. The metal core substrate as claimed in claim 2,
wherein one of the core metal plates adjacent to each other having the gap therebetween is provided with a convex portion projected toward the other core metal plate, and
wherein the other core metal plate is provided with a concave portion where the convex portion is positioned.

5. An electrical junction box comprising:
the metal core substrate claimed in any one of claims 1 to 4,
and distributing electric power respectively inputted into the core metal plates from a plurality of power sources.
